Europäisches Patentamt

European Patent Office

Office européen des brevets

(11) Veröffentlichungsnummer : **0 019 610**
**B1**

# EUROPÄISCHE PATENTSCHRIFT

(45) Veröffentlichungstag der Patentschrift :
**30.03.83**

(21) Anmeldenummer : **80890052.6**

(22) Anmeldetag : **09.05.80**

(51) Int. Cl.³ : **G 03 C   9/08**, G 03 B 15/00,
**B 44 B   1/02**, B 23 Q 33/00

(54) **Verfahren zur fotografischen Herstellung von Datenträgern für die Reproduktion dreidimensionaler Objekte, Vorrichtung zur Ausübung des Verfahrens und Reproduktionsvorrichtung.**

(30) Priorität : **11.05.79 AT 3530/79**

(43) Veröffentlichungstag der Anmeldung :
**26.11.80 Patentblatt 80/24**

(45) Bekanntmachung des Hinweises auf die Patenterteilung : **30.03.83 Patentblatt 83/13**

(84) Benannte Vertragsstaaten :
**BE CH DE FR GB IT LI LU NL SE**

(56) Entgegenhaltungen :
DE A 2 031 217
DE C 403 593
FR A 1 346 973
FR A 2 140 788
GB A 939 261
GB A 939 262
GB A 1 376 941
US A 2 335 127
US A 2 350 796
US A 2 502 697
US A 3 338 766
US A 3 884 577
US E 25 930

(73) Patentinhaber : **Chlestil, Gustav**
**Magdalenalei 51**
**B-2130 Brasschaat (BE)**

(72) Erfinder : **Chlestil, Gustav**
**Magdalenalei 51**
**B-2130 Brasschaat (BE)**

(74) Vertreter : **Krause, Ernst, Dipl.-Ing. et al**
**Dipl.- Ing. Krause Ernst Dipl. Ing. Casati Wilhelm**
**Patentanwälte Amerlingstrasse 8**
**A-1061 Wien (AT)**

## Verfahren zur fotografischen Herstellung von Datenträgern für die Reproduktion dreidimensionaler Objekte, Vorrichtung zur Ausübung des Verfahrens und Reproduktionsvorrichtung

Die Erfindung betrifft ein Verfahren zur fotografischen Herstellung von Datenträgern für die Reproduktion dreidimensionaler Objekte, insbes. menschlicher Köpfe, wobei eine Vielzahl von jeweils in einer insbes. vertikalen Ebene gelegenen Schichtlinien aufeinanderfolgend fotografisch in Einzelbildern festgehalten werden. Mit Hilfe derartiger Verfahren ist es möglich, sämtliche für die Reproduktion notwendigen Meßdaten eines dreidimensionalen Objektes in kürzester Zeit und ohne Berührung des Objektes zu erreichen.

Es sind bereits Verfahren zur Herstellung von Datenträgern auf fotografischem Wege bekannt, bei welchen meist ein Lichtraster oder auch Schichtlinien auf den menschlichen Kopf projiziert werden, um zu einem späteren Zeitpunkt auf ein zu bearbeitendes Modell rückübertragen zu werden. Ein Verfahren dieser Art ist etwa in der US-PS 2 015 457 beschrieben. Eine ähnliche Lösung offenbart auch die US-PS 2 335 127. Bei einem aus der US-E 25 930 bekanntgewordenen Verfahren werden bei jeder Fotografie des Objektes zwangsläufig die Objektumrisse ebenfalls aufgenommen. Für die Reproduktion werden im allgemeinen dann nur die Schichtlinien abgetastet. Bei einem Verfahren, das aus der US-PS 3 884 577 bekannt wurde, wird eine einzelne Lichtlinie in einer horizontalen Ebene auf den Kopf projiziert, sodaß eine um den Kopf herumlaufende, in einer horizontalen Ebene gelegene Schichtlinie in Gestalt eines Lichtbandes erzeugt wird, die auf einem fotografischen Film festgehalten wird. Der die Lichtlinie erzeugende Projektor wird in vertikaler Richtung verschoben, sodaß eine Vielzahl von Schichtlinien, deren jede jeweils in einer horizontalen Ebene gelegen ist, produziert werden.

Die vorgenannten bekannten Verfahren erscheinen zunächst als für den gesamten menschlichen Kopf bzw. das dreidimensionale Objekt brauchbar, erwiesen sich jedoch in der Praxis nicht als vollständig befriedigend, insbes. dann nicht, wenn das menschliche Haar, vor allem wenn es sich um eine Dunkelhaarfarbe handelt, auf einen Datenträger fotografisch aufgezeichnet werden soll. Das menschliche Haar weist nämlich — bedingt durch seine Oberflächenstruktur — nur mangelndes Reflexionsvermögen auf und kann daher kaum eine exakte Schichtlinie darauf produziert werden. Soll daher auch das menschliche Haar einwandfrei reproduziert werden, so sind nach den bekannten Verfahren komplizierte Nachbearbeitungsvorgänge, vor allem auf Grund von fotografischen Aufnahmen des dreidimensionalen Objektes, auf dem auch die Haare voll ersichtlich sind, erforderlich. Bei einem durch die US-PS 2 335 127 bekanntgewordenen Verfahren wird nun auf einem Bild neben einer Vielzahl von jeweils in einer Vertikalebene gelegenen Schichtlinien auch eine im Kontrast verstärkte (durch Beleuchtungsanordnung auf der der Kamera abgewandten Seite) Umrißlinie ohne weitere Strukturlinien aufgezeichnet. Die Differenzierung der einzelnen aufgezeichneten, Linien stößt hiebei auf Schwierigkeiten, wodurch die Reproduktion jedenfalls erschwert, wenn nicht sogar unmöglich gemacht wird. Darstellungsformen des menschlichen Kopfes durch Wiederhabe der Silhouette in Form sogenannter Scherenschnitte sind bereits bekannt. Die Anfertigung einer Vielzahl derartiger Scherenschnitte ermöglicht aber für sich allein noch nicht die exakte Wiedergabe des Kopfes, weil an der Silhouette konkave Stellen des dreidimensionalen Objektes nicht erfaßt werden können, die ihrerseits jedoch den Gesichtsausdruck entscheidend bestimmen.

Der Erfindung liegt nun die Aufgabe zugrunde, den vorerwähnten Mängeln abzuhelfen und ein Verfahren der eingangs erwähnten Art so weiter zu bilden, daß bei dessen Anwendung auch jene Teile eines dreidimensionalen Objektes sicher reproduziert werden können, die auf Grund ihrer Oberflächenstruktur nur unvollkommene Schichtlinien entstehen lassen. Insbes. trifft dies auf jene Bereiche des menschlichen Kopfes zu, die von Haaren bedeckt sind.

Die der Erfindung zugrundeliegende Aufgabe wird dadurch gelöst, daß bei einem Verfahren der eingangs erwähnten Art zusätzlich zu den Schichtlinienaufnahmen auch Silhouetten, i. e. im Kontrast verstärkte (durch Beleuchtungsanordnung auf der der Kamera abgewandten Seite) Umrißlinien ohne weitere Strukturlinien fotografisch festgehalten werden und daß sowohl die Schichtlinie als auch die Silhouette auf einem g ;meinsamen Datenträger (Lichtbild) aufgezeichnet werden, wobei die Schichtlinie in unterschiedlicher Helligkeit oder Farbe gegenüber der Helligkeit oder Farbe der Silhouette aufgezeichnet wird. Dadurch, daß gemäß dem erfindungsgemäßen Verfahren auf dem Datenträger sowohl Schichtlinien als auch Silhouetten des zu reproduzierenden dreidimensionalen Objektes gut differenzierbar aufgezeichnet werden, liegt für die Reproduktion eine vollständige Information vor, die es erlaubt, das Objekt in äußerst exakter Weise wiederzugeben, insbes. auch jene Bereiche, deren Oberflächenstruktur bei der Aufzeichnung durch Schichtaufnahmen Schwierigkeiten bereitet, wobei in diesen Bereichen (Haare) die Wiedergabe der Außenkontur entscheidend ist, nicht aber die Wiedergabe von einspringenden Stellen. Die Aufzeichnung der Schichtlinie in unterschiedlicher Helligkeit oder Farbe gegenüber der Helligkeit oder Farbe der Silhouette sichert hiebei in einfacher Weise eine Differenzierung, d. h. ein Auseinanderhalten dieser nach unterschiedlichen Verfahren gewonnenen Daten, wenn auf einer einzigen Aufnahme sowohl die Silhouette als auch die Schichtlinie, die sich in einer bestimmten Position einstellt, auf dem Datenträger festgehalten sind.

Erfolgt die Aufzeichnung in unterschiedlicher Farbe, so kann durch entsprechende Filterung bei der Reproduktion jeweils eine der auf dem Datenträger vorhandenen Informationen zum Verschwinschwinden gebracht werden, sodaß nur mehr eine Information jeweils sichtbar bleibt.

Die vorgenannte Aufgabe kann bei einem Verfahren der eingangs erwähnten Art jedoch auch gelöst werden, daß zusätzlich zu den Schichtlir.enaufnahmen auch Silhouetten, i. e. im Kontrast verstärkte (durch Beleuchtungsanordnung auf der der Kamera abgewandten Seite (Umrißlinien ohne weitere Strukturlinien photographisch festgehalten werden und daß abwechselnd eine Schichtlinie und eine Silhouette aufgezeichnet werden, bevorzugt dadurch, daß die die Silhouette und die Schichtlinie erzeugenden Lichtquellen abwechselnd im Takt gezündet werden. Die Anwendung dieser Verfahrensführung ermöglicht in einfacher Weise, Schichtlinien und Silhouettenbilder getrennt voneinander aufzuzeichnen. Durch die Aufnahme von Schichtlinien in Kombination mit der Aufzeichnung von Silhouetten nach den erfindungsgemäßen Verfahren wird eine Möglichkeit geboten, sowohl konkave Stellen, die den Gesichtsausdruck prägen, differenziert zu erfassen und exakt zu reproduzieren als auch die Körperform der Haare in die Daten miteinzubeziehen.

Das erfindungsgemäße Verfahren kann mittels verschiedener Vorrichtungen ausgeführt werden. Hiebei ist es bevorzugt, wenn in einem um eine im wesentlichen vertikale Achse drehbaren, schrittweise weiterschaltbaren Gestell, gegeneinander unverrückbar, die Projektionseinrichtung mit Schlitzblende, die Aufnahmeeinrichtung und der Projektionseinrichtung sowie der Aufnahmeeinrichtung zugeordnete Umlenkspiegel angeordnet sind und wenn in dem Gestell weiters mindestens eine Projektionsfläche fixiert ist, die von einer zwischen der Drehachse und der Projektionsfläche ·befindlichen Lichtquelle anstrahlbar ist und wenn weiters in dem Gestell ein bezüglich der Drehachse des Gestells auf der anderen Seite gelegener, das Silhouettenbild zeigender Spiegel fixiert ist.

Durch Anordnung der für die Aufzeichnung von Schichtlinien und Silhouetten wesentlichen Einrichtungen in einem Gestell ist in besonders einfacher Weise die kontinuierliche Aufzeichnung der Silhouetten- und der Schichtlinieninformation sichergestellt. Durch schrittweises Weiterdrehen des Gestelles ist es möglich, beliebig viele Informationen von einem dreidimensionalen Objekt zu erhalten, wobei die Schaltschritte der besonderen Form des Objektes angepaßt werden können, derart, daß an komplizierten Stellen kleinere Schaltschritte ausgeführt werden, um hier besonders genaue Informationen zu erhalten, wogegen an weniger komplizierten Stellen des Objektes größere Schaltschritte ausgeführt werden können.

Zur Erzielung einer Überdeckung der einzelnen Schichtlinien ist es vorteilhaft, wenn in Weiterbildung der Erfindung die Projektionseinrichtung mindestens zwei mit Schlitzblenden versehene Projektoren umfaßt, die auf dem Gestell so justiert sind, daß eine Begrenzung des von der Schlitzblende erzeugten, gegebenenfalls von Umlenkspiegeln gegen die Drehachse gerichteten Lichtbandes mit der geometrischen Drehachse des Gestelles zusammenfällt und die optischen Achsen der beiden Projektoren bevorzugt jeweils einen Winkel von ungefähr 90° miteinander einschließen.

Um mit einer Aufnahme zwei Silhouettenbilder zu erhalten, wird weiters vorgesehen, daß an dem Gestell zwei Projektionsflächen bevorzugt um 90° bezüglich der Drehachse des Gestelles gegeneinander versetzt, befestigt sind, wobei die beiden, diesen Projektionsflächen zugeordneten, jeweils ein Silhouettenbild zeigenden Spiegeln die beiden Silhouettenbilder an eine mit dem Gestell fest verbundene Kamera über dachartig aneinanderstoßende Umlenkspiegel liefern. Hiebei kann die Aufnahmeeinrichtung für die Schichtlinien zwei Kameras umfassen, deren optische Achsen sich im wesentlichen in der Drehachse des Gestelles schneiden und einen Winkel einschließen, der größer 90°, jedoch kleiner 120° sind, wobei die optische Achse einer jeden Kamera den Winkel zwischen den optischen Achsen von jeweils zwei ihr benachbarten Projektoren halbiert. Mit einer wie vorstehend beschrieben ausgebildeten Einrichtung ist es möglich, ein dreidimensionales Objekt rundum bei Drehung des Gestelles um bloß 90° zu erfassen.

Eine Vereinfachung der Vorrichtung ist erzielbar, wenn in besonderer Ausgestaltung der Erfindung in dem Gestell in der Drehachse oberhalb des für die Unterbringung des Aufnahmeobjektes vorgesehenen Raumes eine Kamera angeordnet ist, mit der sowohl die Schichtlinien als auch die Silhouetten aufgenommen werden. Hiebei kann die Wiedergabe der Silhouette und der Schichtenlinien mittels zweier voneinander getrennter Spiegel erfolgen, die im Gestell befestigt sind, wobei diese Spiegel auf verschiedenen Seiten der Drehachse des Gestelles, zueinander im wesentlichen parallel, jedoch gegen die vertikale Mittenebene um einen von 90° verschiedenen ·Winkel verschwenkt angeordnet sind und im Strahlengang der Kamera oberhalb des Aufnahmeobjektes zwei Umlenkspiegel angeordnet sind, deren Ebenen sich in der optischen Achse der Kamera schneiden, die jedoch auf unterschiedlichen Seiten der vertikalen Längsmittenebene angeordnet sind. Eine demgegenüber einfachere Ausführung sieht jedoch vor, daß der bezüglich der Drehachse des Gestelles der Projektionsfläche gegenüberliegende, das Silhouettenbild zeigende Spiegel im Winkel zwischen den beiden Projektoren angeordnet ist und damit auch die von den Schlitzblenden der Projektoren erzeugten Schichtlinien zeigt, wobei bevorzugt die optischen Achsen der Projektoren in einer auf die Drehachse des Gestelles senkrechten Ebene liegend angeordnet sind.

Die Erfindung wird nachstehend anhand der Zeichnung beispielsweise näher erläutert. Es zeigen,

Figur 1 eine erste Ausführungsform einer Vorrichtung zur Durchführung des erfindungsgemäßen Verfahrens in Draufsicht,

Figur 2 einen Teilschnitt entlang der Linie II-II in Fig. 1,

Figur 3 einen Schnitt entlang der Linie III-III in Fig. 1,

Figur 4 einen Schnitt entlang der Linie IV-IV in Fig. 1, die

Figuren 5-7 Bildausschnitte von Aufnahmen der bei der Ausführungsform gamäß Fig. 1 eingesetzten Kameras in der Lage des Gestelles, auf dem die Kameras befestigt sind,

Figur 8 eine gegenüber Fig. 1 abgeänderte Ausführungsform einer Vorrichtung zur Durchführung des erfindungsgemäßen Verfahrens in Draufsicht,

Figur 9 einen Längsmittenschnitt durch die Vorrichtung gemäß Fig. 8,

Figur 10 ein Detail aus Fig. 8,

Figur 11 eine gegenüber den Fig. 8 und 9 modifizierte Vorrrichtung,

Figur 12 einen Schnitt entlang der Linie XII-XII in Fig. 11,

Figur 13 ein Detail aus Fig. 11,

Figur 14 schematisch eine Reproduktionseinrichtung in Draufsicht,

Figur 15 einen teilweise geschnittenen Aufriß, zugeordnet der Fig. 14,

Figur 16 in Draufsicht eine Anordnung zur Aufnahme eines Silhouettenbildes des dreidimensionalen Objekts, und

Figur 17 eine Vorrichtung zur Bearbeitung eines Rohlings, mit der schrittweise Silhouetten aufgrund von nach Fig. 16 aufgezeichneten Silhouettenbildern hergestellt werden.

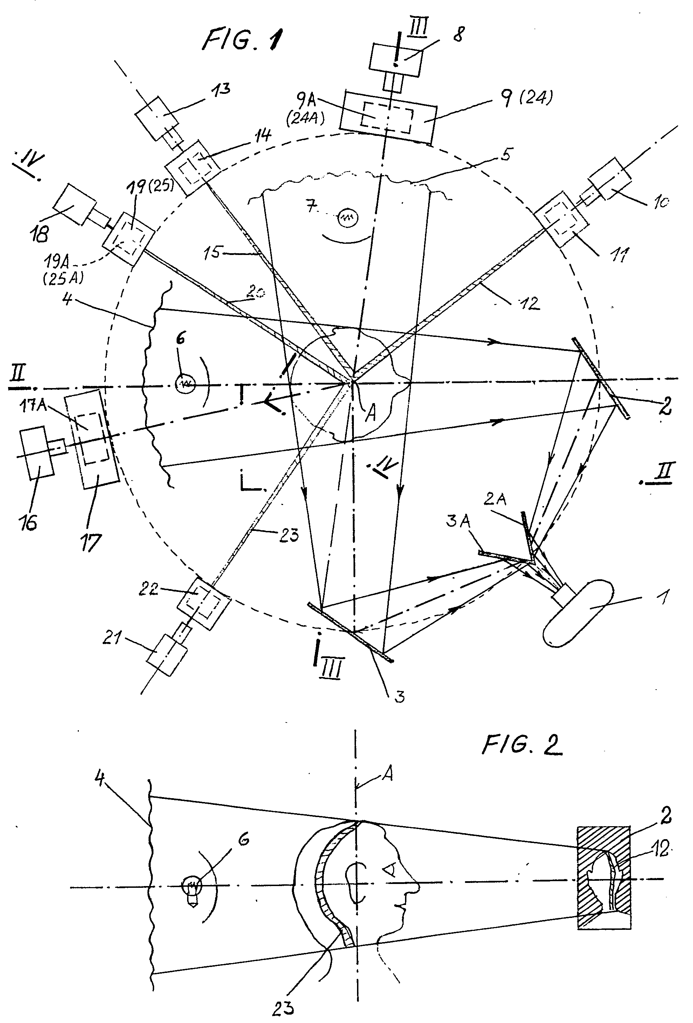

Im Zentrum der Fig. 1 befindet sich das Aufnahmeobjekt, ein menschlicher Kopf. In einem um eine im wesentlichen vertikale Achse A drehbaren, schrittweise weiterschaltbaren (nicht dargestellten) Gestell sind gegeneinander unverrückbar die Projektionseinrichtung mit Schlitzblende, die Aufnahmeeinrichtung sowie die der Projektions- und der Aufnahmeeinrichtung zugeordneten Umlenkspiegel angeordnet. Bei der Ausführungsform gemäß Fig. 1 besteht die Aufnahmeeinrichtung aus drei Kameras 1, 8 und 16, die Projektionseinrichtung aus vier Projektoren 10, 13, 18 und 21. Diese Projektoren erzeugen jeweils ein über eine Schlitzmaske erzeugtes schmales, senkrechtes Lichtband, das in der Zeichnung mit 12 bzw. 15 bzw. 20 bzw. 23 bezeichnet ist. Für die Silhouette sind noch zwei Projektionsflächen 4 und 5 vorgesehen, die ebenfalls am Gestell befestigt sind. Durch eine Drehung des Gestells um 90° können sämtliche benötigten Positionsdaten des zu reproduzierenden Kopfes erhalten werden.

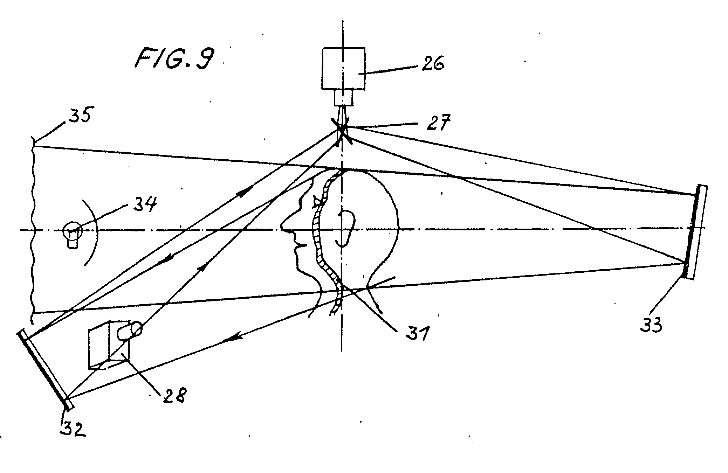

Das zur Kamera 1 gehörige System dient zur Aufnahme der Silhouetten des Kopfes. Beleuchtungskörper 6 und 7 strahlen jeweils die Projektionsflächen 4 und 5 an, wodurch auf den Spiegeln 2 und 3 jeweils ein Silhouettenbild entsteht, welches über Umlenkspiegeln 2a und 3a der Kamera 1 zugeleitet werden. Aus Fig. 2 ist die Projektionsfläche 4, der Beleuchtungskörper 6 sowie der Umlenkspiegel 2 mit dem Bild der Silhouette ersichtlich. Die Form des auf den Kopf projizierten Lichtbandes 23 ist ebenfalls in Fig. 2 ersichtlich. Fig. 7 zeigt das Bild der Kamera 1, welches aus zwei gleich großen Bildflächen besteht, die für sich jedes einzeln eine der beiden Silhouettenaufnahmen wiedergeben. Geht man davon aus, daß bei Drehung des Systems jede Kamera pro Grad ein Bild macht, befinden sich in Kamera 1 somit insgesamt 180 Silhouettenaufnahmen, was praktisch die Konturenpositionen des gesamten Kopfumfanges abdeckt, da die beiden Spiegel 2 und 3 gegeneinander im Winkel von 90° angeordnet sind.

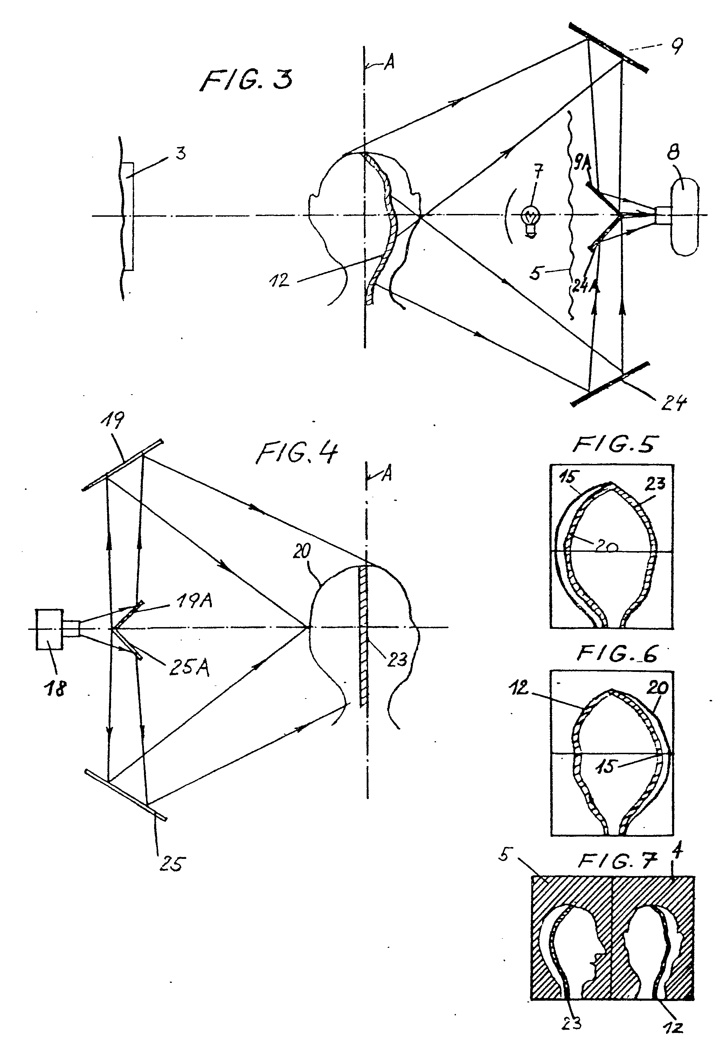

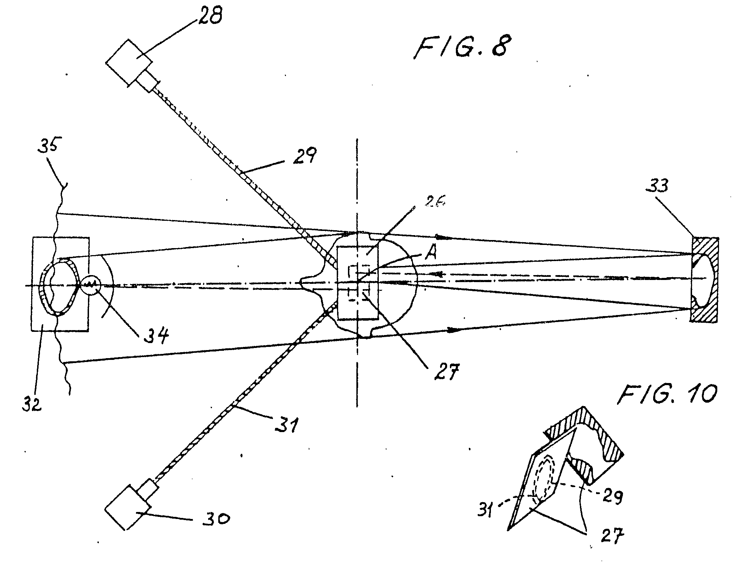

Die unter einem 90° übersteigenden Winkel gegeneinander versetzt angeordneten Aufnahmesysteme der Kameras 8 und 16 sind in ihrer Gesamtausstattung praktisch gleich. Aus Fig. 3 ist ersichtlich, daß die Kamera 8 horizontal in der Höhe der Mitte des Aufnahmeobjektes angeordnet ist. Das Bild der Kamera 8 setzt sich, wie Fig. 6 zeigt, aus zwei Hälften zusammen, einem oberen Teil der über die Spiegel 9 und 9a der Kamera 8 zugeführt wird, und einem unteren Teil, der über die Spiegel 24 und 24a weitergegeben wird. Die spezielle Anordnung der Spiegel 9 und 24 dient zur besseren Einsicht in die zurückfliehenden Teile des menschlichen Kopfes, wie beispielsweise der Kinnpartie, sodaß auch in diesem Teil exakt die verlaufenden Schichtenlinien aufgenommen werden können. Jeder Projektor 10, 13, 18 und 21 erzeugt über eine Schlitzmaske ein schmales senkrechtes Lichtband 12, 15, 20, 23, das auf den Kopf projiziert wird. Die Projektoren 10 und 13 gehören zum System der Kamera 8, die Projektoren 18 und 21 zum System der Kamera 16. Die äußeren Kanten des Lichtbandes, im Verhältnis zu der jeweils zugeordneten Kamera gesehen, gehen genau durch die senkrechte Achse A des gesamten Systems. Diese äußere Hell-/Dunkelgrenze stellt für die spätere Reproduktion die gewünschte Profillinie dar. Um, so wie im Bereich der Kameras, eine exakte Ausleuchtung der zurückfliehenden Teile des Kopfes zu ermöglichen, wird auch bei den Projektoren 10, 13, 21 das senkrecht verlaufende Lichtband über entsprechende Spiegelanordnungen 11, 14, 22 (Fig. 1) auf den Kopf projiziert. Fig. 4 läßt dies für den linken, mit einem Spiegelsystem 19, 19A, 25, 25A arbeitenden Projektor 18 des Systems mit der Kamera 16 und einem Spiegelsystem 17, 17A analog dem Spiegelsystem 9, 9A, 24, 24A der Kamera 8 (Fig. 3) erkennen. Fig. 5 zeigt das Bild der Kamera 16.

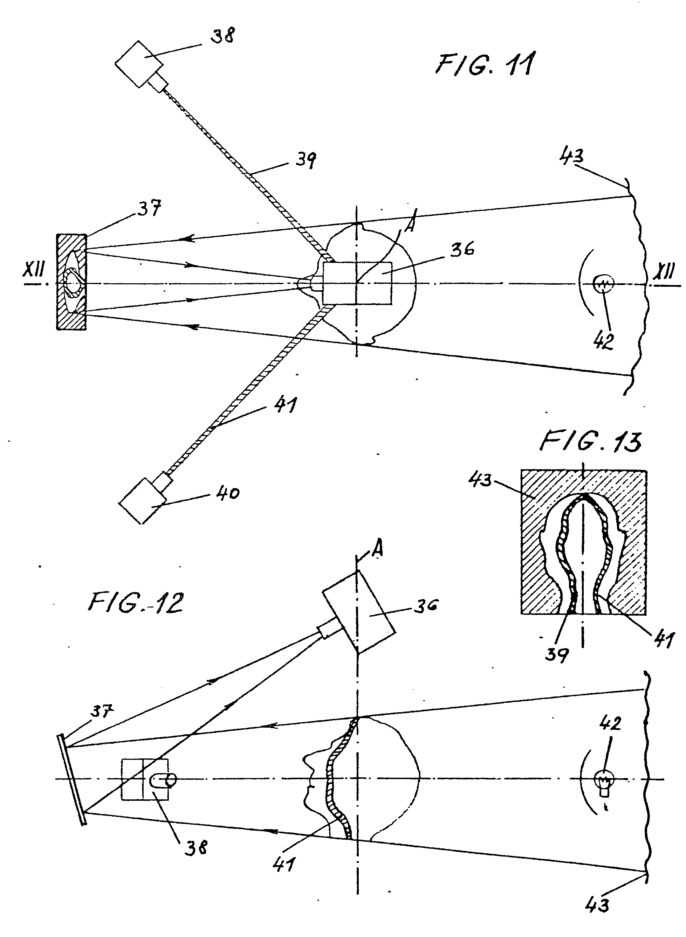

Fig. 8 zeigt eine weitere Anordnungsmöglichkeit der Aufnahmeapparatur, die sich vor allem durch eine vereinfachte technische Ausrüstung auszeichnet. Es wird dabei nur mit einer einzigen Kamera 26 gearbeitet, wobei das Aufnahmesystem in diesem Fall allerdings eine Drehung von insgesamt 180° absolvieren muß, um sämtliche Positionsdaten für die Reproduktion zu erhalten. Die senkrecht über dem Aufnahmeobjekt angeordnete Kamera 26 erhält über den in Fig. 10 im Detail dargestellten Doppelspiegel 27 ebenfalls ein zusammengesetztes Bild. Die eine Bildhälfte zeigt das über den Spiegel 33 erzielte Silhouettenbild, welches sich gegen die durch den Beleuchtungskörper 34 angestrahlte Projektionsfäche 35 abzeichnet. Die andere Bildhälfte kommt über den Umlenkspiegel 32, der die beiden von den Projektoren 28 und 30 projizierten Lichtbänder wiedergibt. Da die Silhouettenaufnahmen praktisch im Bereich der Haare alle notwendigen Positionsdaten abgeben (konkave Stellen im Bereich der Haare können auf Basis von einigen getrennt aufgenommenen Fotos manuell einfach nachmodelliert werden, ohne daß dadurch Ähnlichkeitseinbußen entstehen) können auf Grund der Anatomie des Gesichtes mit einer Anordnung des Spiegels 32 unter der horizontalen Gesichtsmittenebene die durch die Lichtbänder erzielten Profillinien im notwendigen Bereich ebenfalls erzielt werden. Wesentlich ist hier vor allem der Bereich unter der Nase sowie der Bereich zwischen Kinn und Hals. In diesem Falle genügt es selbstverständlich auch, wenn die Projektoren 28 und 30 aus dem gleichen, tiefgestellten Winkel das Lichtband auf den Kopf werfen, ohne dafür noch Spiegelumlenksysteme benützen zu müssen. Auch hier werden wieder die vom Spiegel 32 aus gesehen äußeren Konturen der Lichtbänder 29 und 31 als Profillinien verwendet, da sie genau durch die senkrechte Mitte (Drehachse A des Gestelles) des Gesamtsystems projiziert werden. Die Spiegel 32, 33 sind auf verschiedenen Seiten der Drehachse A des Gestells, zueinander parallel, jedoch gegen die vertikale Mittenebene um einen von 90° (wenig) verschiedenen Winkel verschwenkt angeordnet. Die Ebenen der im Strahlengang der Kamera 26 oberhalb des Aufnahmeobjektes angeordneten Spiegel 27 schneiden sich in der optischen Achse der Kamera 26, die jedoch auf unterschiedlichen Seiten der vertikalen Längsmittenebene angeordnet ist.

Fig. 11 zeigt eine weitere Ausführungsmöglichkeit der Aufnahmeapparatur. Die Anlage arbeitet ebenfalls nur mit einer Kamera 36, benötigt jedoch nur einen Umlenkspiegel 37. Für die Silhouette wird eine beleuchtete Projektionsfläche 43 und zur Erzeugung der Schichtenlinien werden zwei Projektoren 38, 40 benötigt. Bei einer Gesamtdrehung um das Aufnahmeobjekt von 180° werden alle benötigten Positionsdaten erzielt. Bei dieser Anordnung wird das Aufnahmeobjekt in einer leicht nach hinten geneigten Position in der Mitte des Systems placiert. Über den Umlenkspiegel 37 erhält die Kamera 36 ein Bild, das sowohl die Silhouette als auch die beiden Profillinien in einem enthält, wie Fig. 13 zeigt. Die Projektionsfläche 43 wird durch einen Beleuchtungskörper 42 angestrahlt. Die beiden Projektoren 38 und 40 produzieren die beiden senkrechten Lichtbänder, von denen wieder die äußere Kontur im Verhältnis zum Spiegel 37, die beiden Profillinien darstellen. Durch die nach hinten geneigte Position des Aufnahmeobjektes kann auch in diesem Fall

der Spiegel 37 alle notwendigen Bereiche der Profillinien im Gesichtsfeld erfassen.

Um für die mechanische Reproduktion, die automatische Abtastung der Konturenlinien zu erleichtern, können drei verschiedene Verfahren vorgesehen werden. In der ersten Variante werden auf dem Bild (Fig. 13) drei verschiedene Helligkeitswerte dargestellt. Die Helligkeit der durch den Beleuchtungskörper 42 angeleuchteten Projektionsfläche 43 wird nur halb so groß ausgesteuert, wie die der beiden Lichtbänder 39 und 41 auf dem Aufnahmeobjekt. Dadurch stellen sich auf dem Bild (Fig. 13) drei verschiedene Zonen dar. Der unbeleuchtete Teil des Kopfes, der die beiden Lichtbänder 39 und 41 und, in der Lichtintensität nur halb so stark hervortretend, der Hintergrund 43. In der zweiten Variante wird mit Farbaufnahmematerial gearbeitet. Die Projektoren 38 und 40 erzeugen mittels eines Farbfilters Beispielsweise jeweils ein grünes senkrechtes Lichtband, während der Hintergrund in rot angestrahlt wird. Bei der Rückprojektion können somit durch entsprechende Farbfilterung jeweils nur die gewünschten Bilder wiedergegeben werden, also beispielsweise allein die Lichtbänder 39 und 41, oder aber allein die Silhouette gegen den Hintergrund 43. In der dritten Variante schließlich bestehen die Lichtquellen in den Projektoren 38 und 40 sowie der Beleuchtungskörper 42 aus Stroboskopen. Durch eine mit der Kamera 36 synchronisierte Steuerung wird jeweils einmal der Hintergrund angeblitzt, während die Projektoren 38 und 40 unbeleuchtet bleiben, beim nächsten Bild wieder blitzen die Stroboskope durch die Projektoren 38 und 40 die beiden Lichtbänder auf das Aufnahmeobjekt, während der Hintergrund 43 dunkel bleibt. Dadurch ergeben sich wechselseitig Bilder der Silhouette oder aber der beiden Lichtbänder.

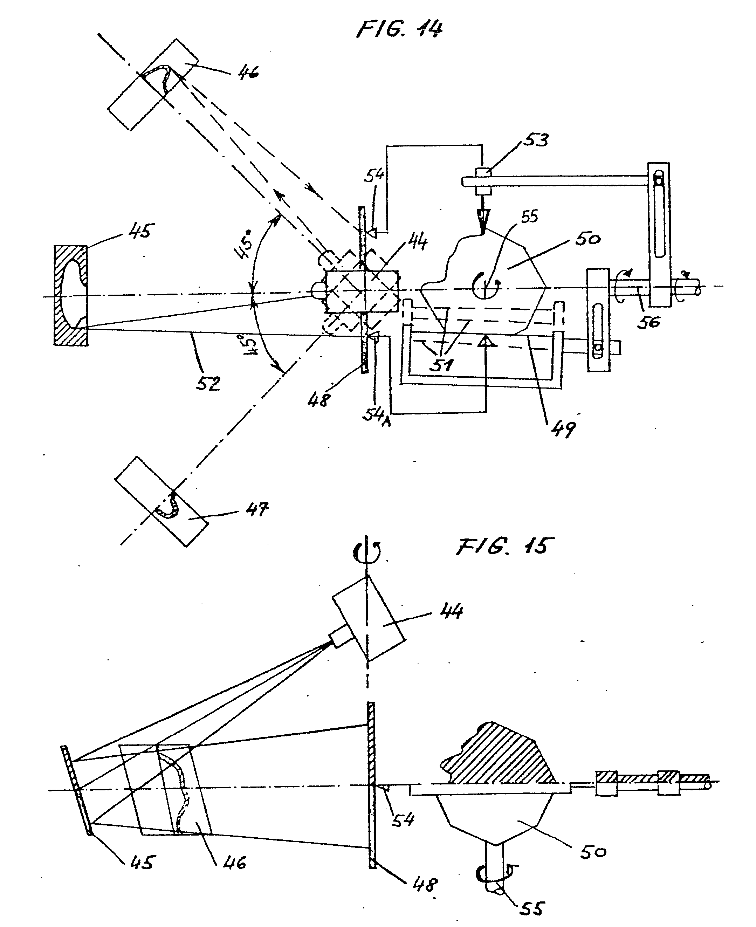

Ein Ausführungsbeispiel der Reproduktionsanlage wird nachstehend anhand der Fig. 14ff beschrieben. Das in diesen Figuren dargestellte Reproduktionssystem bezieht sich auf eine Datenaufzeichnung, die mit einer Anlage gemäß den Fig. 11 und 12 vorgenommen wurde. Das gezeigte Prinzip gilt jedoch auch sinngemäß bei entsprechender Anpassung der Systeme für die Aufnahmeapparaturen aus Fig. 1 und Fig. 8.

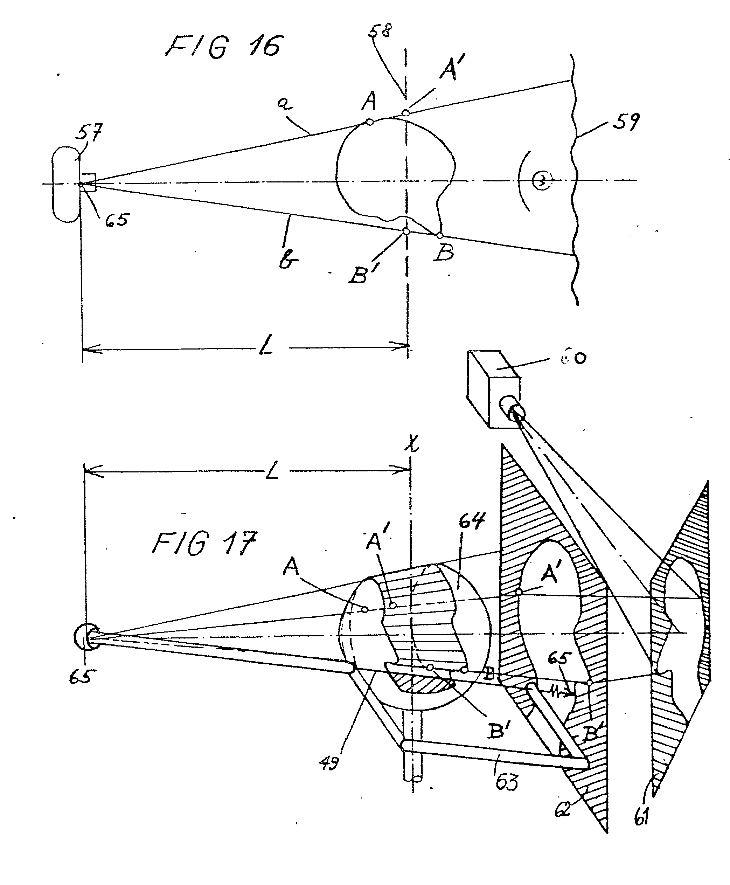

Über einer Mattscheibe 48 befindet sich der um eine Mittelachse schwenkbare Projektor 44. Die Umlenkspiegel 45, 46 und 47 sind für die notwendige Rückprojektion aus der Aufnahmeanlage bestimmt. Auf der anderen Seite der Mattscheibe 48 befindet sich auf einer parallel dazu, somit senkrecht verlaufenden Welle 55 der Materialrohling 50, aus dem der Kopf herausgearbeitet werden soll. Der Rohling 50 ist um 360° drehbar. Der Projektor 44, auf den Umlenkspiegel 45 gerichtet, produziert auf der Mattscheibe 48 das Bild der Silhouette (Fig. 13). Auf einer Welle 56 befindet sich ein Schneidebogen mit einem Schneidedraht 49, der um ca. 300° um den Rohling 50 kreisförmig herumgeführt werden kann. Das Abtastelement 54a fährt nunmehr der Silhouette nach und steuert parallel den Schneidebogen kreisförmig (Welle 56) um den Materialrohling 50, wobei die Mitte des Drahtes 49 praktisch genau dem Verlauf der Silhouette folgt. Wichtig ist dabei, daß die Neigung des Schneidedrahtes 49 immer der Neigung des jeweiligen Projektionsstrahles wie hier beispielsweise des mit 52 bezeichneten Projektionsstrahles entspricht. Das heißt der Draht 49 muß von seiner Mitte aus immer den gleichen Fluchtpunkt auf der waagrechten Anlagenmitte haben, was gleichzeitig der Gesamtentfernung Mattscheibe zu Projektor entspricht. Nur auf diese Weise ist der räumliche Schnitt nach einer planen Silhouette richtig zu erzielen, da das Bild dazu aus einem zentralen Punkt auf die Mattscheibe geworfen wird. Die strichlierten Stellungen 51 des Schneidedrahtes 49 zeigen, daß die Verlängerung der Linie immer auf denselben Fluchtpunkt zukommen muß. Im theoretischen Fall, daß der Schneidedraht 49 bis zur Systemmitte kommt, muß er praktisch die Mittellinie genau deckend mit dieser gleichlaufen. Zur Verdeutlichung des Vorstehenden dienen die Fig. 16 und 17. Aus Fig. 16 kann man das Grundprinzip der Aufnahme des dreidimensionalen Objektes im Grundriß sehen. Für die Kamera bildet sich die Silhouette des Kopfes gegen den hellen Hintergrund 59 ab. Ein beispielsweise eingetragener Sichtstrahl a tangiert das Objekt im Punkte A, während ein weiterer Sichtstrahl b im Punkte B den Kopf berührt. Stellt man sich nunmehr für die Rückprojektion an Stelle der Kamera 57 einen Projektor vor, der das aufgenommene Bild projiziert und weiters in der Systemmitte eine Mattscheibe 58 (wobei es entscheidend ist, daß vom Brennpunkt der Kamera bis zur Systemmitte die gleiche Länge L bestand, wie diese zwischen dem Brennpunkt des Projektors und der Mattscheibe 58 vorzusehen ist), so wird der Punkt A auf der Mattscheibe 58 an der Stelle A' und der Punkt B auf der Mattscheibe 58 an der Stelle B' abgebildet. Um nunmehr mit einem tangential schneidenden, im Querschnitt punktförmigen Schneideelement, wie beispielsweise einem Heißdraht, richtig zu schneiden, wird das Schneidelement auf der gedachten Ebene der Mattscheibe 58 durch die Punkte A' und B' geführt. Um jedoch an den tatsächlich gewünschten Punkten A und B richtig zu schneiden, muß die Verlängerung des Drahtes jeweils immer im gemeinsamen Punkt 65 auf der Anlagenmitte enden, wobei in der praktischen Ausführung dieser Punkt als Kniegelenk ausgebildet ist. Dies heißt praktisch, je größer der Durchmesser des Aufnahmeobjektes ist, desto größer wird der Winkel zwischen Anlagenachse und Schneidedraht 49.

Eine Möglichkeit der praktischen Ausführung ist in Fig. 17 dargestellt. Der Projektor 60 projiziert über einen Spiegel 61 ein Silhouettenbild auf eine transparente Mattscheibe 62. Der Spiegel 61 ist deshalb notwendig, da der Projektor 60 an der Stelle des gemeinsamen Fluchtpunktes, also im Kugelgelenk 65, angeordnet werden müßte, um auf die Mattscheibe 62 zu projizieren. Da dies jedoch aus bautechnischen Gründen nicht möglich ist, wird von der gegenüberliegenden Seite projiziert, was jedoch die Umkehrung des Bildes durch den Spiegel 61 notwendig macht. Im Kugelgelenk 65, das den zentralen Fluchtpunkt bildet, ist ein Schneidebogen 63 verankert, in dem sich der Schneidedraht 49 befindet. Über das sich in der Verlängerung des Schneidedrahtes 49 befindende Abtastelement 65 kann nunmehr der Silhouette auf der Mattscheibe 62 nachgefahren werden. Da die Mattscheibe 62 eigentlich in der Achsenmitte x mit der Entfernung L zum Fluchtpunkt (Kugelgelenk 65) liegen müßte, dies jedoch aus bautechnischen Gründen ebenfalls nicht möglich ist, wird die Mattscheibe 62 in aus der Achsmitte W verschobener Position aufgestellt. Dies bedingt natürlich eine entsprechende Vergrößerung des Silhouettenbildes dergestalt, daß bei dem gegebenen Strahlengang in der Systemmitte (Achse x) das Silhouettenbild in richtiger Größe wiedergegeben wird. Nun schneidet der Schneidedraht 49 aus dem Rohling 64 eine kegelförmige Fläche heraus, die der vorgegebenen Silhouette entspricht. Obwohl der Draht praktisch durch die Punkte A' und B' gesteuert wird, schneidet er, bedingt durch den gemeinsamen Fluchtpunkt (Kugelgelenk 65), an den Punkten A und B in der richtigen Position. Hat der Schneidebogen 63 die gesamte Silhouette abgefahren, wird vom Projektor 60 das nächste Silhouettenbild auf die Mattscheibe geworfen. Ist das Silhouettenbild beispielsweise nach einer Drehung des Objektes von einem Grad gegenüber der vorangegangenen Aufnahme aufgenommen worden, so wird auch der Rohling 64 auf der Welle x um 1 Grad weitergedreht, sodaß das folgende Bild wieder in der richtigen Position geschnitten werden kann.

Wieder zurückkommend auf Fig. 14, die die Produktionsanlage in ihrer Gesamtheit darstellt, sei festgehalten, daß in diesem Falle die Neigung des Schneidedrahtes 49 zur Systemmitte, dergestalt, daß die Verlängerung immer den gleichen Fluchtpunkt durchläuft, durch eine entsprechende Bewegungsmechanik erreicht wird.

Für den Schnitt der Schichtlinien wird ein kegeliger Fräser 53 verwendet, der praktisch der Profillinie ebenfalls im Umfang von ca. 300° um den Rohling 50 herum nachgeführt werden kann. Auch hier nimmt das Abnahmeelement 54 die Linie ab und überträgt sie auf den Fräser 53, wobei dabei gleichzeitig sowohl der Drehvorschub der Welle 56 als auch die Bewegung von und zum Mittelpunkt des Rohlings 50 gesteuert werden. Es kann bei der Reproduktion der Profillinien jedoch immer nur ein Halbbild projiziert werden. Der Projektor schwenkt zu diesem Zwecke entweder auf den Spiegel 47 oder auf den Spiegel 46. Im vorliegenden Falle wurde strichliert der Strahlengang über den Spiegel 46 dargestellt. Die Mattscheibe 48 entspricht in diesem Falle der äußeren Kante des Lichtbandes des linken Projektors 38 in der Aufnahmeanlage. Auf der Mattscheibe 48 bildet sich nunmehr, ohne Verzerrung, die genaue Profillinie ab und kann vom Abtastelement 54 auf der anderen Seite der Mattscheibe 48 nachgefahren werden. Auch hier wird eine Hälfte bearbeitet, wobei im Projektor das folgende Bild nachfolgt und der Rohling 50 auf der Welle 55 den dazu entsprechenden Gradschritt mitdreht.

Schwenkt der Projektor auf den Spiegel 47, entspricht die Mattscheibe 48 dem Lichtband des rechten Projektors 40 aus der Aufnahmeapparatur. Es bildet sich auf der Mattscheibe 48 somit die rechte Kante des Lichtbandes als Profillinie für die benötigte Kontur ab. Auch diese Linie ist durch die Rückprojektion im 45° Winkel praktisch wieder entzerrt. Auch auf dieser Seite fährt das Abtastelement 54 der entsprechenden Profillinie nach und überträgt die Bewegung auf den Fräser 53. Es versteht sich von selbst, daß der Fräser 53 oder der Schneidebogen mit dem Schneidedraht 49 nur alternativ zum Einsatz kommt.

Der in der Beschreibung verwendete Begriff « photographische Herstellung von Datenträgern » schließt sinngemäß auch eine Herstellung von Datenträgern mittels Fernsehkamera und Speicherung z. B. auf Magnetband und Wiedergabe auf einen elektronischen Bildschirm ein. Anstelle der in den Zeichnungen dargestellten Filmkameras treten dann Fernsehkameras und für die Reproduktion tritt an die Stelle der Mattscheibe 48 ein elektronischer Bildschirm.

### Ansprüche

1. Verfahren zur photographischen Herstellung von Datenträgern für die Reproduktion dreidimensionaler Objekte, insbes. menschlicher Köpfe, wobei eine Vielzahl von jeweils in einer insbesondere vertikalen Ebene gelegenen Schichtlinien aufeinanderfolgend photographisch in Einzelbildern festgehalten werden, dadurch gekennzeichnet, daß zusätzlich zu den Schichtlinienaufnahmen auch Silhouetten, i. e. im Kontrast verstärkte (durch Beleuchtungsanordnung auf der der Kamera abgewandten Seite) Umrißlinien ohne weitere Strukturlinien photographisch festgehalten werden und daß sowohl die Schichtlinie als auch die Silhouette auf einem gemeinsamen Datenträger (Lichtbild) aufgezeichnet werden, wobei die Schichtlinie in unterschiedlicher Helligkeit oder Farbe gegenüber der Helligkeit oder Farbe der Silhouette aufgezeichnet wird.

2. Verfahren zur photographischen Herstellung von Datenträgern für die Reproduktion dreidimensionaler Objekte, insbes. menschlicher Köpfe, wobei eine Vielzahl von jeweils in einer insbesondere vertikalen Ebene gelegenen Schichtlinien aufeinanderfolgend photographisch in Einzelbildern festgehalten werden, dadurch gekennzeichnet, daß zusätzlich zu den Schichtlinienaufnahmen auch Silhouetten, i. e. im Kontrast verstärkte (durch Beleuchtungsanordnung auf der der Kamera abgewandten Seite) Umrißlinien ohne weitere Strukturlinien photographisch festgehalten werden und daß abwechselnd eine Schichtlinie und eine Silhouette aufgezeichnet werden, bevorzugt dadurch, daß die die Silhouette und die Schichtlinie erzeugenden Lichtquellen abwechselnd im Takt gezündet werden.

3. Vorrichtung zur Durchführung des Verfahrens nach Anspruch 1 oder 2, dadurch gekennzeichnet, daß in einem um eine im wesentlichen vertikale Achse (A) drehbaren, schrittweise weiterschaltbaren Gestell, gegeneinander unverrückbar, die Projektionseinrichtung mit Schlitzblende, die Aufnahmeeinrichtung und der Projektionseinrichtung sowie der Aufnahmeeinrichtung zugeordnete Umlenkspiegel angeordnet sind und daß in dem Gestell weiters mindestens eine Projektionsfläche fixiert ist, die von einer zwischen der Drehachse und der Projektionsfläche befindlichen Lichtquelle anstrahlbar ist und daß in dem Gestell ein bezüglich der Drehachse des Gestells auf der anderen Seite gelegener, das Silhouettenbild zeigender Spiegel fixiert ist.

4. Vorrichtung nach Anspruch 3, dadurch gekennzeichnet, daß die Projektionseinrichtung mindestens zwei mit Schlitzblenden versehene Projektoren umfaßt, die auf dem Gestell so justiert sind, daß eine Begrenzung des von der Schlitzblende erzeugten, gegebenenfalls von Umlenkspiegeln gegen die Drehachse gerichteten Lichtbandes mit der geometrischen Drehachse des Gestells zusammenfällt und die optischen Achsen der beiden Projektoren bevorzugt jeweils einen Winkel von ungefähr 90° miteinander einschließen.

5. Vorrichtung nach Anspruch 3 oder 4, dadurch gekennzeichnet, daß an dem Gestell zwei Projektionsflächen (4, 5) bevorzugt um 90° bezüglich der Drehachse des Gestells gegeneinander versetzt, befestigt sind, wobei die beiden, diesen Projektionsflächen (4, 5) zugeordneten, jeweils ein Silhouettenbild zeigenden Spiegel (2, 3) die beiden Silhouettenbilder an eine mit dem Gestell fest verbundene Kamera (1) über dachartig aneinanderstoßende Umlenkspiegel (2A, 3A) liefern (Fig. 1, 2, 7).

6. Vorrichtung nach einem der Ansprüche 3 bis 5, dadurch gekennzeichnet, daß die Aufnahmeeinrichtung für die Schichtlinien zwei Kameras (8, 16), gegebenenfalls Fernsehkameras mit Bildspeichereinrichtung, umfaßt, deren optische Achsen sich im wesentlichen in der Drehachse des Gestells schneiden und einen Winkel einschließen, der größer 90°, jedoch kleiner 120° ist, wobei die optische Achse einer jeden Kamera (8, 16) den Winkel zwischen den optischen Achsen von jeweils zwei ihr benachbarten Projektoren (10, 13, 18, 21) halbiert (Fig. 1).

7. Vorrichtung nach Anspruch 3 oder 4, dadurch gekennzeichnet, daß in dem Gestell in der Drehachse oberhalb des für die Unterbringung des Aufnahmeobjektes vorgesehenen Raumes eine Kamera (26, 36) angeordnet ist, mit der sowohl die Schichtlinien als auch die Silhouetten aufgenommen werden (Fig. 8-13).

8. Vorrichtung nach Anspruch 7, dadurch gekennzeichnet, daß für die Wiedergabe der Silhouette und der Schichtlinien zwei voneinander getrennte Spiegel (33, 32) im Gestell befestigt sind, wobei diese Spiegel (33, 32) auf verschiedenen Seiten der Drehachse des Gestelles, zueinander im wesentlichen parallel, jedoch gegen die vertikale Mittenebene um einen von 90° verschiedenen Winkel verschwenkt angeordnet sind und daß im Strahlengang der Kamera (26) oberhalb des Aufnahmeobjektes zwei Umlenkspiegel (27) angeordnet sind, deren Ebenen sich in der optischen Achse der Kamera (26) schneiden, die jedoch auf unterschiedlichen Seiten der vertikalen Längsmittenebene angeordnet sind (Fig. 8, 9, 10).

9. Vorrichtung nach Anspruch 7, dadurch gekennzeichnet, daß der bezüglich der Drehachse des Gestells der Projektionsfläche (43) gegenüberliegende, das Silhouettenbild zeigende Spiegel (37) im Winkel zwischen den beiden Projektoren angeordnet ist und damit auch die von den Schlitzblenden der Projektoren (38, 40) erzeugten Schichtlinien (39, 41) zeigt, wobei bevorzugt die optischen Achsen der Projektoren (38, 40) in einer zur Drehachse des Gestells senkrechten Ebene angeordnet sind (Fig. 11-13).

10. Einrichtung zur Reproduktion eines dreidimensionalen Objektes, insbes. eines menschlichen Kopfes unter Verwendung von Daten, aufgezeichnet nach einem Verfahren gemäß den Ansprüchen 1 oder 2 bzw. mit einer Vorrichtung nach einem der Ansprüche 4 bis 9, dadurch gekennzeichnet, daß zur Reproduktion der Silhouette ein linienförmiges Element (49), z. B. ein Schneiddraht, eine rotierende Fräsnadel, eine Drahtbandsäge od. dgl. und zur Reproduktion der Schichtlinien ein Fingerfräser (53) vorgesehen ist, der unabhängig vom linienförmigen Element für die Reproduktion der Silhouette bewegbar ist, wobei sowohl das linienförmige Element als auch der Fingerfräser (53) schwenkbar um die gleiche, senkrecht zur Drehachse des Fingerfräsers (53) und senkrecht zur Ebene einer Mattscheibe bzw. eines elektronischen Bildschirmes (48) stehende Achse (56) schwenkbar gelagert sind, daß ein Projektor (44) zur Projektion bzw. elektronischen Wiedergabe der Datenträger vorgesehen ist, der um eine Achse schwenkbar ist, die in der Ebene der Mattscheibe bzw. des Bildschrims (48) liegt, wobei zur Wiedergabe der Silhouette auf der Mattscheibe (48) bzw. dem Bildschirm die optische Achse des Projektors (44) in einer die Schwenkachse (56) des linienförmigen Elementes enthaltenden, senkrecht zur Mattscheibe (48) bzw. dem Bildschirm stehenden Ebene liegt und ein Umlenkspiegel (45) vorgesehen ist, der die optische Achse des Projektors (44) in den Durchstoßpunkt der Schwenkachse (56) des linienförmigen Elementes mit der Mattscheibe (48) bzw. mit dem Bildschirm projiziert und die Steuerung des linienförmigen Elementes durch einen der auf die Mattscheibe bzw. den Bildschirm geworfenen Silhouettenkontur nachführbaren Taster (54a) erfolgt, wobei die Richtung (51) des linienförmigen Elementes (49) parallel zu jenem Projektionsstrahl verläuft, der dem jeweiligen Silhouettenpunktzugeordnet ist und daß zur Projektion der Schichtlinien auf die Mattscheibe (48) bzw. den Bildschirm der Projektor aus der Mittelstellung um den gleichen, bevorzugt ± 45° betragenden Winkel ausschwenkbar ist, den bei der Aufzeichnung der Daten, die optische Achse des mit der Schlitzblende versehenen Projektors mit der Mittenebene eingeschlossen hat, wobei ein Umlenkspiegel (46 bzw. 47) vorgesehen ist, der die optische Achse des Projektors (44) in den Durchstoßpunkt der Schwenkachse (56) des Fingerfräsers (53) projiziert, wobei zur Steuerung des Fingerfräsers ein der Projektion der Schichtlinie auf die Mattscheibe (48) bzw. auf den Bildschirm nachführbarer Taster (54) vorgesehen ist (Fig. 14, 15).

11. Einrichtung nach Anspruch 10, dadurch gekennzeichnet, daß der Rohling (50) um eine lotrechte Achse (55) schrittweise schwenkbar ist, welche auf der Schwenkachse (56) des linienförmigen Elementes (49) und der des Fingerfräsers (53) senkrecht steht (Fig. 14, 15).

**Claims**

1. A method of photographically producing data carriers for the reproduction of three-dimensional objects, particularly human heads, wherein a multiplicity of contour lines, each of which extends in a particularly vertical plane, are photographically recorded in succession as individual images, characterized in that in addition to the contour lines, silhouettes, i. e., contour lines having an increased contrast (by the provision of a source of illumination on the side remote from the camera) are photographically recorded without additional structure lines and the contour line and the silhouette are recorded on a common data carrier (photograph), on which the record of the contour line differs in brightness or colour from the record of the silhouette.

2. A method of photographically producing data carriers for the reproduction of three-dimensional objects, particularly human heads, wherein a multiplicity of contour lines, each of which extends in a particularly vertical plane, are photographically recorded in succession as individual images, characterized in that in addition to the contour lines, silhouettes, i. e., contour lines having an increased contrast (by the provision of a source of illumination on the side remote from the camera) are photographically recorded without additional structure lines and a contour line and a silhouette are recorded in alternation, preferably in that the light sources which generate the silhouette and the contour line are periodically lighted in alternation.

3. Apparatus for carrying out the method according to claim 1 or 2, characterized in that a frame is provided, which is rotatable about a substantially vertical axis (A) and adapted to be advanced in steps, the projecting means provided with a slit, the recording means and deflecting mirrors associated with the projecting means and the recording means are mounted in said frame and immovable relative to each other, at least one screen is secured in the frame and is adapted to be irradiated from a light source disposed between the axis of rotation and the screen, and a mirror showing the silhouette image is mounted in the frame and disposed on the other side with respect to the axis of rotation of the frame.

4. Apparatus according to claim 3, characterized in that the projecting means comprises at least two projectors, which are provided with slits and are so adjusted on the frame that a boundary of the light band which is generated by the slit and, if desired, is directed to the axis of rotation by deflecting mirrors, coincides with the geometric axis of rotation of the frame, and the optical axes of the two projectors preferably include an angle of about 90° with each other.

5. Apparatus according to claim 3 or 4, characterized in that two screens (4, 5) are secured to the frame and are preferably spaced 90° apart with respect to the axis of rotation of the frame, and the two mirrors (2, 3) which are associated with said screens (4, 5) and show respective silhouette images deliver the two silhouette images via deflecting mirrors (2A, 3A), which abut like a roof, to a camera (1), which is firmly connected to the frame ((Fig. 1, 2, 7).

6. Apparatus according to any of claims 3 to 5, characterized in that the means for recording the contour lines comprise two cameras (8, 16) consisting, if desired, of television cameras provided with an image memory, the optical axes of said cameras intersect substantially in the axis of rotation of the frame and include an angle which exceeds 90° but is less than 120°, and the optical axis of each camera (8, 16) bisects the angle between the optical axes of two projectors (10, 13 ; 18, 21) which are adjacent to said camera (Fig. 1).

7. Apparatus according to claim 3 or 4, characterized in that a camera (26, 36) for recording the contour lines as well as the silhouettes is provided in the frame in the axis of rotation above the space provided for accomodating the object to be recorded (Fig. 8 to 13).

8. Apparatus according to claim 7, characterized in that two separate mirrors (33, 32) for reproducing the silhouette and the contour lines are secured in the frame and disposed on different sides of the axis of rotation of the frame and substantially parallel to each other but turned toward the vertical centre plane by an angle differing from 90°, and two deflecting mirrors (27) are disposed in the optical path of the camera (26) above the object to be recorded and on different sides of the vertical longitudinal centre plane and define planes which intersect in the optical axis of the camera (Fig. 8, 9, 10).

9. Apparatus according to claim 7, characterized in that the mirror (37) which is opposite to the screen (43) with respect to the axis of rotation of the frame and shows the silhouette image is disposed in the angular space between the two projectors and thus shows also the contour lines (39, 41) generated by the slits of the projectors (38, 40) and the optical axes of the projectors (38, 40) are preferably disposed in a plane that is at right angles to the axis of rotation of the frame (Fig. 11 to 13).

10. Apparatus for reproducing a three-dimensional object, particularly a human head, with the aid of data recorded by a method according to claim 1 or 2 or by apparatus according to any of claims 4 to 9, characterized in that a linear element (49), e. g., a cutting wire, a rotating milling needle, a wire band saw or the like is provided for reproducing the silhouette, and an end mill (53) is provided for reproducing the contour lines and is movable independently of the linear element for reproducing the silhouette, the linear element and the end mill (53) are pivoted on the same axis (56), which is at right angles to the axis of rotation of the end mill (53) and at right angles to the plane of a ground glass screen or an electronic display screen (48), a projector (44) for projecting or electronically reproducing the data carriers is provided and is pivoted on an axis which is disposed in the plane of the ground glass screen or display screen (48), for the reproduction of the silhouette on the ground glass screen (48) or the display screen the optical axis of the projector (44) extends in a plane that includes the pivotal axis (56) of the linear element and is at right angles to the ground glass screen (48) or the display screen, and a deflecting mirror (45) is provided, which projects the optical axis of the projector (44) to the point of intersection of the pivotal axis (56) of the linear element with the ground glass screen (48) or the display screen, the linear element is controlled by a scanning element (54a), which is movable along the contour of a silhouette thrown onto the ground glass screen or the display screen, and the direction (51) of the linear element (49) is parallel to that projected ray which is associated with the corresponding point of the silhouette, and for the projection of the contour lines on the ground glass screen (48) or display screen the projector is pivotally movable out of the central position by the same angle, preferably amounting to ± 45°, which the optical axis of the projector provided with the slit included with the centre plane during the recording of the data, a deflecting mirror (46 or 47) is provided, which projects the optical axis of the projector (44) into the point of intersection of the pivotal axis (56) of the end mill (53), and a scanning element (54), which is movable along the projection of the contour line on the ground glass screen (48) or the display screen is provided for controlling the end mill (Fig. 14, 15).

11. Apparatus according to claim 10, characterized in that the blank (50) is incrementally pivotally movable about a vertical axis (55) which is at right angles to the pivotal axis (56) of the linear element (49) and the pivotal axis of the end mill (53) (Fig. 14, 15).

## Revendications

1. Procédé pour la production de supports de données par voie photographique pour la reproduction d'objets tridimensionnels, en particulier, de la tête du corps humain, plusieurs lignes de relief situées chacune dans un plan, en particulier, vertical, étant fixées successivement par voie photographique en images individuelles, caractérisé en ce que, en plus des prises de vues des lignes de relief, on fixe également photographiquement des silhouettes, c'est-à-dire des contours plus contrastés (par un système d'éclairage sur le côté éloigné de la chambre photographique) sans autres lignes structurales tandis que, aussi bien la ligne de relief que la silhouette sont enregistrées sur un support de données commun (image de lumière), la ligne de relief étant enregistrée en une luminosité ou une couleur différente de celle de la silhouette.

2. Procédé pour la production de supports de données par voie photographique pour la reproduction d'objets tridimensionnels, en particulier, de la tête du corps humain, plusieurs lignes de relief situées chacune dans un plan, en particulier, dans un plan vertical étant fixées successivement par voie photographique en images individuelles, caractérisé en ce que, en plus des prises de vues des lignes de relief, on fixe également photographiquement des silhouettes, c'est-à-dire des contours plus contrastés (par un système d'exposition sur le côté éloigné de la chambre photographique) sans autres lignes structurales, tandis que l'on enregistre alternativement une ligne de relief et une silhouette, de préférence, en allumant alternativement en cadence les sources lumineuses produisant la silhouette et la ligne de relief.

3. Dispositif pour la réalisation du procédé suivant la revendication 1 ou 2, caractérisé en ce que dans un bâti pouvant être déplacé progressivement et pouvant tourner sur un axe essentiellement vertical (A), on installe, de manière fixe les uns par rapport aux autres, le dispositif de projection comportant un diaphragme à fente, le dispositif de prise de vue et le miroir d'inflexion attribué au dispositif de projection, ainsi qu'au dispositif de prise de vue et, en outre, dans ce bâti, on fixe au moins une surface de projection qui peut être éclairée par une source lumineuse se trouvant entre l'axe de rotation et cette surface de projection, un miroir reproduisant l'image de la silhouette et situé de l'autre côté vis-à-vis de l'axe de rotation du bâti étant également fixé dans ce dernier.

4. Dispositif suivant la revendication 3, caractérisé en ce que le dispositif de projection comprend au moins deux projecteurs pourvus de diaphragmes à fente qui sont ajustés sur le bâti de telle sorte qu'une limite de la bande lumineuse produite par le diaphragme à fente et éventuellement dirigée par des miroirs d'inflexion vers l'axe de rotation, coïncide avec l'axe de rotation géométrique du bâti, tandis que les axes optiques des deux projecteurs définissent, de préférence, chaque fois un angle d'environ 90° l'un avec l'autre.

5. Dispositif suivant la revendication 3 ou 4, caractérisé en ce que, sur le bâti, on fixe deux surfaces de projection (4, 5), de préférence, décalées l'une de l'autre de 90° par rapport à l'axe de rotation du bâti, les deux miroirs (2, 3) attribués à ces surfaces de projection (4, 5) et reproduisant chacun une image d'une silhouette fournissant les deux images de silhouette à une chambre photographique (1) assemblée fermement au bâti, via des miroirs d'inflexion (2A, 3A) se touchant en forme de toit (figures 1, 2, 7).

6. Dispositif suivant une des revendications 3 à 5, caractérisé en ce que le dispositif de prise de vue pour les lignes de relief comprend deux chambres photographiques (8, 16), ainsi qu'éventuellement des caméras de télévision avec dispositif de mémorisation d'image, dont les axes optiques s'intersectent essentiellement sur l'axe de rotation du bâti et définissent un angle supérieur à 90°, mais inférieur à 120°, l'axe optique de chacune des chambres photographiques (8, 16) bissectant l'angle formé entre les axes optiques de deux projecteurs voisins de chacune de ces chambres (10, 13 ; 18, 21) (figure 1).

7. Dispositif suivant la revendication 3 ou 4, caractérisé en ce que, dans le bâti et dans l'axe de rotation, au-dessus de l'espace prévu pour installer l'objet de la prise de vue, est installée une chambre photographique (26, 36) avec laquelle on prend des prises de vues aussi bien des lignes de relief que des silhouettes (figures 8-13).

8. Dispositif suivant la revendication 7, caractérisé en ce que, pour la reproduction de la silhouette et des lignes de relief, on fixe deux miroirs (33, 32) séparés l'un de l'autre dans le bâti, ces miroirs (33, 32) étant disposés essentiellement parallèlement l'un à l'autre de différents côtés de l'axe de rotation du bâti, en étant cependant inclinés d'un angle différent de 90° vis-à-vis du plan médian vertical tandis que, dans le parcours des rayons de la chambre photographique (26), au-dessus de l'objet de la prise de vue, sont disposés deux miroirs d'inflexion (27) dont les plans s'intersectent sur l'axe optique de la chambre photographique (26), mais qui sont situés sur des côtés différents du plan médian longitudinal vertical (figures 8, 9, 10).

9. Dispositif suivant la revendication 7, caractérisé en ce que le miroir (37) qui reproduit l'image de la silhouette et qui, vis-à-vis de l'axe de rotation du bâti, est opposé à la surface de projection (43), est disposé dans l'angle entre les deux projecteurs et représente ainsi également les lignes de relief (39, 41) produites par les diaphragmes à fente des projecteurs (38, 40), les axes optiques des projecteurs (38, 40) étant, de préférence, disposés dans un plan perpendiculaire à l'axe de rotation du bâti (figures 11-13).

10. Dispositif pour la reproduction d'un objet tridimensionnel, en particulier, d'une tête d'un corps humain en utilisant des données enregistrées suivant un procédé selon les revendications 1 ou 2 ou avec un dispositif selon les revendications 4 à 9, caractérisé en ce que, pour la reproduction de la silhouette, on prévoit un élément linéaire (49), par exemple, un fil coupant, une aiguille de fraisage rotative, une scie à ruban ou analogues et, pour la reproduction des lignes de relief, on prévoit une fraise à queue (53) pouvant se déplacer indépendamment de l'élément linéaire pour la reproduction de la silhouette, aussi bien l'élément linéaire que la fraise à queue (53) étant montés de façon à pouvoir pivoter sur le même axe (56) s'étendant perpendiculairement à l'axe de rotation de la fraise à queue (53) et au plan d'un disque mat ou d'un écran électronique (48), tandis que, pour la projection ou la reproduction électronique des supports de données, on prévoit un projecteur (44) monté de façon à pouvoir pivoter sur un axe situé dans le plan du disque mat ou de l'écran (48) et, pour la reproduction de la silhouette sur le disque mat (48) ou sur l'écran, l'axe optique du projecteur (44) est situé dans un plan renfermant l'axe de pivotement (56) de l'élément linéaire et disposé perpendiculairement au disque mat (48) ou à l'écran, tandis que l'on prévoit un miroir d'inflexion (45) qui projette l'axe optique du projecteur (44) dans le point de percée de l'axe de pivotement (56) de l'élément linéaire avec le disque mat (48) ou l'écran, la commande de l'élément linéaire ayant lieu au moyen d'un palpeur (54a) pouvant suivre le contour de la silhouette projetée sur le disque mat ou sur l'écran, la direction (51) de l'élément linéaire (49) s'étendant parallèlement au rayon de projection qui est attribué à chaque point de la silhouette et, pour la projection des lignes de relief sur le disque mat (48) ou l'écran, le projecteur peut pivoter à partir de la position centrale sur le même angle (atteignant, de préférence, ± 45°) que celui défini, lors de l'enregistrement des données, entre l'axe optique du projecteur pourvu du diaphragme à fente et le plan médian, un miroir d'inflexion (46 ou 47) étant prévu pour projeter l'axe optique du projecteur (44) ou point de percée de l'axe de pivotement (56) de la fraise à queue (53) et, pour commander cette dernière, on prévoit un palpeur (54) pouvant suivre la projection de la ligne de relief sur le disque mat (48) ou sur l'écran (figures 14 et 15).

11. Dispositif suivant la revendication 10, caractérisé en ce que l'ébauche (50) peut pivoter progressivement autour d'un axe vertical (55) qui s'étend perpendiculairement à l'axe de pivotement (56) de l'élément linéaire (49) et à celui de la fraise à queue (53) (figures 14 et 15).

FIG. 1

FIG. 2

FIG. 3

FIG. 4

FIG. 5

FIG. 6

FIG. 7

FIG. 8

FIG. 10

FIG.9

**0 019 610**

*FIG. 11*

*FIG. 12*

*FIG. 13*

FIG. 14

FIG. 15

6

FIG 16

FIG 17